# EUROPÄISCHE PATENTSCHRIFT

(11) **EP 3 111 527 B1**
(45) Veröffentlichungstag und Bekanntmachung des Hinweises auf die Patenterteilung: **05.12.2018**
(21) Anmeldenummer: 15700052.2
(22) Anmeldetag: 07.01.2015
(51) Int. Cl.: H02H 3/02, H02H 3/087, H02H 7/18, H02H 9/00, B60R 16/00, G01R 31/02, H02J 7/00, H02J 7/14

(54) **BATTERIESYSTEM UND VERFAHREN ZUM BETREIBEN EINES SOLCHEN**
BATTERY SYSTEM AND METHOD FOR OPERATING SUCH A BATTERY SYSTEM
SYSTÈME DE BATTERIE ET PROCÉDÉ SERVANT À FAIRE FONCTIONNER UN SYSTÈME DE BATTERIE DE CE TYPE

(30) Priorität: 26.02.2014 DE 102014203476
(43) Veröffentlichungstag der Anmeldung: 04.01.2017
(73) Patentinhaber: Robert Bosch GmbH, 70442 Stuttgart (DE)
(72) Erfinder: GALAMB, Gergely, 83278 Traunstein (DE); ZIEGLER, Stefan, 75196 Remchingen (DE)
(86) Internationale Anmeldenummer: PCT/EP2015/050136
(87) Internationale Veröffentlichungsnummer: WO 2015/128099

(56) Entgegenhaltungen:
- JP-A- 2008 099 528
- JP-A- 2012 210 032
- US-A1- 2001 028 571

## Beschreibung

Die vorliegende Erfindung betrifft ein Batteriesystem sowie ein Verfahren zum Betreiben eines solchen, insbesondere in einem elektrisch angetriebenen Fahrzeug. Die vorliegende Erfindung betrifft insbesondere ein Verfahren zum Betreiben eines Batteriesystems zum Reduzieren oder Verhindern eines Lichtbogens bei dem Öffnen eines elektronischen Schalters.

### Stand der Technik

In Batteriesystemen für Kraftfahrzeuge werden die einzelnen Batterien oftmals in Reihe geschaltet, um eine hohe Spannung und so bei hohen Leistungen geringe Ströme liefern zu können. Um die Batterie etwa bei einem Stillstand oder bei einem Fehlerfall von dem restlichen Hochvoltsystem beziehungsweise insbesondere dem Verbraucher trennen zu können, werden üblicherweise Schütze an dem positiven und negativen Spannungs-Anschluss für die Traktionsleitungen vorgesehen. Diese Schütze können bei Bedarf und in Abhängigkeit der exakten Ausgestaltung Ströme bis zu etwa 1-2kA trennen. Insbesondere bei einem Öffnen oder Schließen eines Schützes bei hohen Stromstärken kann zwischen den entsprechenden Kontakten ein Lichtbogen, welche einen höheren Widerstand, als der ursprüngliche Kontaktwiderstand des Schützes haben, entstehen, welcher die Kontaktstellen aufschmelzen oder entsprechendes Material abtragen kann, so dass die Bauteile voraltern. Je stärker der Lichtbogen ist, desto mehr Material kann dabei abgetragen werden und sich innerhalb des Schalters verteilen. Dadurch können der Isolationswiderstand und die Spannungsfestigkeit sowohl zwischen den Hauptkontakten, also den Plus- und Minuspolen, als auch zwischen den Hauptkontakten und der Spule, also zwischen dem Hoch-Spannungsbereich (HV) und dem Niedrig -Spannungsbereich (LV), vermindert werden.

Um derartige Effekte zu reduzieren ist es bekannt, parallel zu einem Hauptschalter einen Vorladekreis mit einem Vorladewiderstand und einem Vorladeschalter vorzusehen. Der Hauptschalter wird dabei durch den Vorladekreis beim Zuschaltvorgang überbrückt. Dadurch, dass dann ein Vorladewiderstand in dem Hauptstromkreis vorliegt, kann der fließende Strom begrenzt werden. Beispielsweise bei einem Einschalten kann nach einem definierten Zeitraum nach einem Beenden des Vorladevorgangs das Hauptschütz geschlossen und das Vorladeschütz geöffnet werden, um so einen gewünschten Lade- und Entladevorgang zu ermöglichen.

Das Dokument JP 2008 099528 A, das den nächstliegenden Stand der Technik wiedergibt, offenbart Fahrzeuge, wie etwa elektrisch angetriebene Fahrzeuge und beschreibt dabei insbesondere einen Stromversorgungskreis. Ein derartiger Stromversorgungskreis umfasst einen unterbrechbaren Strompfad, zu dem ein weiterer ebenfalls unterbrechbarer und mit einem Widerstand versehener parallel geschalteter Strompfad vorgesehen ist.

Aus dem Dokument JP 2012 210032 A ist eine elektrische Schaltung für eine Batterie bekannt, welche einen ersten Schalter in einem ersten Strompfad und einen zweiten Schalter und einen Widerstand in einem zweiten Strompfad aufweist, wobei der zweite Strompfad zu dem ersten Strompfad parallel angeordnet ist.

### Offenbarung der Erfindung

Gegenstand der vorliegenden Erfindung ist ein Verfahren zum Betreiben eines Batteriesystems zum Versorgen eines Verbrauchers mit elektrischer Leistung, aufweisend wenigstens eine zwischen einer Batterie und dem Verbraucher angeordneten elektronischen Schalteinheit, wobei wenigstens eine elektronische Schalteinheit einen Hauptstrompfad aufweist, der insbesondere durch einen Hauptschalter öffenbar ist, und wobei die elektronische Schalteinheit einen zu dem Hauptstrompfad parallel angeordneten öffenbaren Nebenstrompfad aufweist, in dem ein Nebenwiderstand und gegebenenfalls ein Nebenschalter angeordnet ist, aufweisend die Verfahrensschritte:
a) Versorgen des Verbrauchers mit elektrischer Leistung, wobei der Hauptstrompfad und der Nebenstrompfad geschlossen sind;
b) Detektieren eines sicherheitskritischen Zustands;
c) Öffnen des Hauptstrompfads, wobei der Widerstandswert des Nebenwiderstands verändert wird.
Durch das vorbeschriebene Verfahren wird es auf einfache Weise möglich, einen potentiell sich ausbildenden Lichtbogen bei einem Auftreten von hohen Strömen und dabei bei einem Öffnen eines Schalters zu minimieren oder bestenfalls vollständig zu verhindern.

Das vorbeschriebene Verfahren dient somit insbesondere dem Betreiben eines Batteriesystems, welches etwa Bestandteil eines zumindest teilweise elektrisch angetriebenen Fahrzeugs sein kann. Das Batteriesystem dient dabei in an sich bekannter Weise zum Versorgen eines Verbrauchers, wie beispielsweise eines Elektromotors, mit elektrischer Leistung. Hierzu umfasst das Batteriesystem eine Batterie mit wenigstens einer Batteriezelle, wie etwa einer Zelle einer Lithium-Ionen-Batterie, vorzugsweise mit einer Mehrzahl an etwa eine Reihe geschalteter Batteriezellen, oder gegebenenfalls eine Mehrzahl an Batterien. Dabei wird die Erfindung im Folgenden mit einer Batterie und einem Verbraucher beschrieben, wobei die Erfindung jedoch in für den Fachmann verständlicher Weise auch das Vorsehen einer Mehrzahl an Verbrauchern und insbesondere einer Mehrzahl an Batterien aufweisen kann. Zwischen der Batterie und dem Verbraucher ist dabei eine elektronische Schalteinheit angeordnet, welche die elektrische Leitung zwischen der Batterie und dem Verbraucher unterbrechen kann. Beispielsweise ist eine derartige Schalteinheit ein an sich bekanntes Schütz.

Die elektronische Schalteinheit kann dabei einen Hauptstrompfad aufweisen, der durch einen Hauptschalter öffenbar ist. Dabei kann im Sinne der vorliegenden Erfindung ein Öffnen eines Strompfads bedeuten, dass kein Strom durch diesen Strompfad fließen kann, wohingegen ein Schließen des Strompfads bedeuten kann, dass dieser einen Strom führen kann. Das Öffnen des Strompfads kann dabei ermöglicht werden durch ein Öffnen eines Schalters, wie etwa des Hauptschalters für den Fall des Hauptstrompfads. Entsprechend kann ein Schließen des Strompfads bedeuten ein Schließen des Schalters wie etwa des Hauptschalters für den Fall des Hauptstrompfads zum Verhindern eines Stromflusses.

Neben dem Hauptstrompfad umfasst die Schalteinheit einen Nebenstrompfad, welcher derart angeordnet ist, dass er zu dem Hauptstrompfad parallel angeordnet ist und diesen somit überbrücken kann. Der Nebenstrompfad ist dabei öffenbar, beispielsweise durch einen in diesem Pfad angeordneten optionalen Nebenschalter. Weiterhin ist in den Nebenstrompfad ein Nebenwiderstand angeordnet, der gegebenenfalls ebenfalls unter anderem dazu dienen kann, den Nebenstrompfad zu unterbrechen beziehungsweise zu öffnen. Ein derartiger Widerstand ist insbesondere ein zusätzlich zu dem Widerstand des Pfades als solchem angeordneter zusätzlicher definierter Widerstand. Durch diesen Widerstand kann somit der Stromfluss durch den Nebenstrompfad begrenzt werden. Für den Fall, dass die elektronische Schalteinheit ein an sich bekanntes Schütz ist, kann der Hauptstrompfad als Hauptschütz bezeichnet werden, wohingegen der Nebenstrompfad als Vorladekreis mit einem Vorladewiderstand und einem Vorladeschütz sein kann.

Das vorbeschriebene Verfahren zum Betreiben eines derartigen Batteriesystems umfasst gemäß Verfahrensschritt a) das Versorgen des Verbrauchers mit elektrischer Leistung, wobei der Hauptstrompfad und der Nebenstrompfadgeschlossen sind. Dieser Verfahrensschritt beschreibt somit das gewünschte Entladen der Batterie und somit das gewünschte und normale Arbeiten des Batteriesystems unter Versorgen beispielsweise eines Elektromotors mit elektrischer Leistung. Bei diesem Verfahrensschritt ist es nunmehr vorgesehen, dass der Hauptstrompfad und der Nebenstrompfad geschlossen sind, etwa indem sowohl der Hauptschalter, als auch der Nebenschalter geschlossen sind. In anderen Worten kann bei einem gewünschten Entladevorgang Strom sowohl durch den Hauptstrompfad als auch durch den Nebenstrompfad fließen. Dies ist ein entscheidender Unterschied zu den Verfahren gemäß dem Stand der Technik, da bei derartigen bekannten Verfahren zum Betreiben eines Batteriesystems ein Nebenstrompfad, wie beispielsweise ein Vorladekreis, in der Regel bei einem gewünschten Arbeiten geöffnet ist, Strom somit lediglich durch den Hauptstrompfad jedoch nicht durch den Nebenstrompfad fließen kann.

Bei dem vorbeschriebenen Verfahren kann zwar eine Erwärmung des in dem Nebenstrompfad angeordneten Widerstands durch den zu dem Hauptstrompfad parallelen Strom erfolgen, jedoch ist der Kontaktwiderstand an dem Hauptschalter deutlich niedriger. Ferner kann beispielsweise durch eine geeignete Ausgestaltung beziehungsweise Dimensionierung des Widerstands ermöglicht werden, dass die Erwärmung des Widerstands in unproblematischen Grenzen bleibt und somit keinen kritischen Wert annimmt. Somit kann durch eine Ausgestaltung in Abhängigkeit der gewünschten Parameter und in Bezug auf die gewünschte Anwendung durch eine definierte Ausgestaltung der einzelnen Komponenten ein problemloses Arbeiten mit einem Stromfluss durch den Hauptstrompfad und den Nebenstrompfad möglich sein.

In einem weiteren Verfahrensschritt b) erfolgt bei dem vorbeschrieben Verfahren ein Detektieren eines sicherheitskritischen Zustands. Unter einem derartigen sicherheitskritischen Zustand kann dabei insbesondere ein solcher verstanden werden, der von einem normalen Arbeiten des Batteriesystems abweicht und beispielsweise und nicht beschränkend einhergeht mit dem Fließen eines erhöhten Stroms. Somit kann beispielsweise unter einem sicherheitskritischen Zustand ein Fehlerfall verstanden werden, bei welchem ein Kurzschluss aufgetreten ist, wodurch ein deutlich vergrößerter Stromfluss insbesondere durch die Schalteinheit auftritt. Beispielsweise umfasst der Fehlerfall beziehungsweise der sicherheitskritische Zustand das Fließen eines definiert und vorbestimmt erhöhten Stroms. Ein derartiger Fehlerfall kann beispielsweise detektierbar sein durch das Vorsehen von entsprechenden Sensoren, wie beispielsweise von Stromsensoren, die zwischen dem Verbraucher und der Batterie, beispielsweise verbunden mit dem Hauptstrompfad, angeordnet sind. Beispielsweise kann ein derartiger Sensor somit den durch den Hauptstrompfad des Schalters fließenden Strom messen.

Dabei können bei dem Übersteigen eines definierten Schwellenwerts etwa durch eine Steuereinheit, definierte Gegenmaßnahmen eingeleitet werden, wie dies nachstehend im Detail erläutert ist.

Für den Fall, dass ein derartiger sicherheitskritischer Zustand auftritt, erfolgt gemäß Verfahrensschritt c) ein Öffnen des Hauptstrompfads.

Beim Öffnen des Hauptstrompfads, etwa bei einem Öffnen des Hauptschalters und damit beim Trennen eines hohen Stroms, entsteht am Hauptschalter durch die Induktivität in der Batterie ein hoher Spannungsabfall (Transiente). Dieser führt dazu, dass im Schalter ein Lichtbogen entsteht, der grundsätzlich die Kontaktoberflächen altert und zur thermischen Beschädigung des Bauteils führen kann. Dadurch, dass nun der Hauptstrompfad geöffnet jedoch der Nebenstrompfad geschlossen ist, kann der Strom nunmehr noch durch den Nebenstrompfad fließen. Der Nebenstrompfad kann somit dazu verwendet werden, die Transiente abzubauen und einen Teil des Stromes zu leiten. Somit wird das Trennen aufgeteilt beispielsweise auf den Hauptschalter und den Schalter im Nebenstrompfad. Dadurch entsteht beim Öffnen des Hauptschalters nur noch ein schwacher Lichtbogen, oder das Auftreten des Lichtbogens kann vollständig verhindert werden. Der Strom fließt nunmehr lediglich durch den Nebenstrompfad und wird durch den Widerstand begrenzt, so dass das Führen zu hoher Ströme begrenzt werden kann.

Das vorbeschriebene Verfahren ermöglicht somit auf einfache Weise, den bei einem sicherheitskritischen Zustand auftretenden Lichtbogen am Hauptschalter zu reduzieren und somit die Beschädigungen an dem Schalter zu minimieren. Dadurch kann die Langlebigkeit eines derartigen Batteriesystems verlängert und entsprechend die Fehlerhäufigkeit reduziert werden. Somit können beispielsweise mit einem derartigen Batteriesystem ausgestattete Fahrzeuge auch nach einem Fehlerfall grundsätzlich weiterarbeiten.

Zusammenfassend ermöglicht ein vorbeschriebenes Verfahren, welches im Wesentlichen basiert auf einer definierten Ansteuerung einer elektrischen Schalteinheit, eine signifikant erhöhte Sicherheit bei einem Betreiben meines Batteriesystems und ferner ein besonders kostengünstiges Betreiben des Batteriesystems.

Es wird ein Nebenwiderstand mit einem veränderbaren Widerstandwert verwendet, wobei der Widerstandswert nach Verfahrensschritt a) sukzessive vergrößert werden kann. Beispielsweise kann ein elektrischer Widerstandswert in einem Bereich von kleiner oder gleich 30 Ohm, insbesondere kleiner oder gleich 15 Ohm, beispielsweise kleiner oder gleich 8 Ohm vorgesehen sein. Beispielsweise wird ein Widerstand verwendet, welcher kurzzeitig niederohmig ist, wie etwa in einem Bereich von 100mOhm und erst nach einer kurzen Zeit hochohmiger wird. Hierfür kann beispielsweise eine Parallelschaltung von mehreren Teilwiderständen verwendet werden. Beim Öffnen des Strompfads beziehungsweise der Strompfade kann dann zunächst der Hauptschalter öffnen und danach die parallel geschalteten Teilwiderstände im Nebenpfad der Reihe nach angesteuert beziehungsweise geöffnet werden, so dass der durch den Nebenstrompfad fließende Strom sukzessive stärker begrenzt werden kann.

Insbesondere eine derartige Ausgestaltung des Nebenwiderstands kann in besonders effektiver und vorteilhafter Weise ermöglichen, dass bei einem Betreiben des Batteriesystems und dadurch insbesondere in dem Moment der Unterbrechung des Stromkreises durch den Hauptschalter ein genügend großer Anteil des Stromes durch den Nebenstrompfad und nur ein begrenzter Strom durch den Hauptstrompfad geleitet werden kann. Der Strom teilt sich somit umgekehrt proportional zum Verhältnis des Widerstandes im Nebenstrompfad und dem Widerstand des Lichtbogens am gerade geöffneten Hauptstrompfad. Dadurch kann in besonders vorteilhafter Weise bei dem Öffnen des Hauptschalters nur noch ein vergleichsweise geringerer Strom durch den Hauptstrompfad fließen als beim Trennen eines Überstromes gemäß dem Stand der Technik, wodurch bei dem Öffnen des Hauptschalters ein besonderes schwacher oder bestenfalls kein Lichtbogen entsteht. Ein weiterer Vorteil eines wie vorstehend beschriebenen ausgestalteten Nebenwiderstands kann darin gesehen werden, dass die Zwischenkreiskapazität beispielsweise eines Fahrzeugs, also der Inverter, schneller aufgeladen ist und der Verbraucher, wie beispielsweise ein Fahrzeug, dadurch schneller einsatzbereit ist.

Im Rahmen einer weiteren Ausgestaltung kann bei einem Versorgen des Verbrauchers mit elektrischer Leistung gemäß Verfahrensschritt a) das Verhältnis des durch den Hauptstrompfad und durch den Nebenstrompfad fließenden Stroms in einem Verhältnis von größer oder gleich 10/1 bis kleiner oder gleich 10⁵/1 liegen. Ein niedriger Strom durch den Haupstromtfad kann insbesondere realisierbar sein durch die Auswahl des in dem Nebenstrompfad angeordneten Widerstands, indem dieser derart ausgestaltet ist, dass ein wie vorstehend beschrieben aufgeteilter Strom fließen kann. Insbesondere in dieser Ausgestaltung kann es ermöglicht werden, dass der Strom, welcher bei einem normalen Betreiben des Batteriesystems durch den Hauptstrompfad fließt, besonders stark begrenzt wird. Dadurch kann bei einem Öffnen des Hauptschalters das Auftreten eines Lichtbogens zwischen den Kontakten des Schalters besonders signifikant reduziert werden.

Im Rahmen einer weiteren Ausgestaltung kann das Verfahren den weiteren Schritt umfassen: d) Öffnen des Nebenstrompfads, insbesondere nach Verfahrensschritt c). In dieser Ausgestaltung kann bei dem Auftreten eines sicherheitskritischen Zustands somit das Fließen eines Stroms vollständig verhindert werden, wodurch eine weitergehende Gefährdung vermieden oder zumindest signifikant reduziert wird. Dies kann beispielsweise realisierbar sein durch das Öffnen eines Nebenschalters oder auch durch das Ansteuern des Nebenwiderstands. In letzterer Ausgestaltung kann somit das Fließen des Stroms durch den Nebenstrompfad durch die Ausgestaltung des Nebenwiderstands vollständig verhindert werden, indem Beispielsweise die Teilwiderstände einen derartig hohen Widerstandswert aufweisen, dass das Fließen eines Stroms verhindert wird. Somit kann in dieser Ausgestaltung beispielsweise auf das Vorsehen eines Nebenschalters verzichtet werden. Dies kann ein besonders kostengünstiges und einfach zu steuerndes Verfahren ermöglichen.

Im Rahmen einer weiteren Ausgestaltung kann als sicherheitskritischer Zustand das Fließen eines definiert erhöhten Stroms detektiert werden. Dabei kann der definiert erhöhte Strom als sicherheitskritischer Zustand beziehungsweise Fehlerfall insbesondere einen Strom umfassen, der über einem definierten Schwellwert liegt und somit ein Gefährdungspotential aufweist.

Hinsichtlich weiterer Vorteile und Merkmale des vorbeschriebenen Verfahrens wird hiermit explizit auf die Erläuterungen im Zusammenhang mit dem erfindungsgemäßen Batteriesystem sowie den Figuren verwiesen. Auch sollen erfindungsgemäße Merkmale und Vorteile des erfindungsgemäßen Verfahrens für das erfindungsgemäße Batteriesystem anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen.

Gegenstand der vorliegenden Erfindung ist ferner ein Batteriesystem gemäß Anspruch 7, welches dazu ausgestaltet ist, ein wie vorstehend beschrieben ausgebildetes Verfahren durchzuführen. Ein derartiges Batteriesystem dient somit insbesondere dem Versorgen eines Verbrauchers mit elektrischer Leistung. Ein derartiger Verbraucher kann beispielsweise ein Elektromotor eines Kraftfahrzeugs sein. Beispielsweise kann das Batteriesystem somit Bestandteil eines zumindest teilweise elektrisch angetriebenen Fahrzeugs sein. Als elektrisch angetriebene Fahrzeuge kommen nicht beschränkend vollständig elektronisch angetriebene Fahrzeuge oder Hybridfahrzeuge in Betracht. Jedoch ist das Batteriesystem nicht auf die vorgenannten Beispiele beschränkt.

Das Batteriesystem umfasst dabei eine Batterie mit insbesondere wenigstens einer Batteriezelle oder vorzugsweise einer Mehrzahl an in Reihe geschalteten Batteriezellen. Die entsprechende Batterie kann beispielsweise eine Lithium-Ionen-Batterie sein, wie sie grundsätzlich aus dem Stand der Technik bekannt sein kann. Zwischen der Batterie und dem elektrischen Verbraucher ist dabei eine elektronische Schalteinheit angeordnet, welche die elektronische Verbindung zwischen der Batterie und dem Verbraucher selektiv herstellen oder trennen kann. Eine derartige elektronische Schalteinheit kann grundsätzlich aus dem Stand der Technik bekannt sein. Die elektronische Schalteinheit, wie beispielsweise das Schütz, umfasst dabei einen ersten Strompfad beziehungsweise Hauptstrompfad, der insbesondere durch einen Hauptschalter öffenbar ist. Dieser Hauptschalter kann auch als Hauptschütz bezeichnet werden. Weiterhin umfasst die elektronische Schalteinheit einen zu dem ersten Strompfad parallel angeordneten zweiten Strompfad beziehungsweise Nebenstrompfad, der ebenfalls unterbrechbar beziehungsweise öffenbar ist, etwa durch einen Nebenschalter, und in dem ein Nebenwiderstand angeordnet ist. Der Nebenstrompfad kann auch als Vorladekreis bezeichnet werden, in welchem ein Vorladewiderstand und ein Vorladeschütz angeordnet sind.

Dem Batteriesystem zugeordnet kann ferner eine Steuereinheit sein, welche die elektronischen Schalteinheit derart ansteuert, dass bei einem gewünschten Entladevorgang, also bei einem Versorgen des Verbrauchers mit elektrischer Energie, sowohl der Hauptstrompfad als auch der Nebenstrompfad geschlossen sind. In anderen Worten steuert das Steuersystem die Schalteinheit beziehungsweise die beiden Schalter beziehungsweise den Widerstand derart an, dass in einem Normalzustand des Batteriesystems und einem gewünschten Entladen der Batterie der Strom sowohl durch den Hauptstrompfad als auch durch den Nebenstrompfad fließen kann.

Weiterhin umfasst das Batteriesystem einen oder eine Mehrzahl an Sensoren, welche einen sicherheitskritischen Zustand beziehungsweise fehlerhaften Betrieb des Batteriesystems detektieren können. Beispielsweise kann ein derartiger sicherheitskritischer Zustand des Batteriesystems das Fließen eines erhöhten Stroms bedeuten, welcher beispielsweise hervorgerufen wird durch einen Kurzschluss in dem Batteriesystem. Ein derartiger Kurzschluss kann beispielsweise hervorgerufen werden durch einen Defekt oder durch einen Unfall. Somit kann ein Sensor zum Detektieren eines fehlerhaften Zustands beispielsweise ein Stromsensor sein.

Wird ein derartiger sicherheitskritischer beziehungsweise fehlerhafter Zustand durch den Sensor detektiert, kann die Steuereinheit daraufhin den Schalter derart ansteuern, dass der Hauptstrompfad geöffnet wird, etwa durch das Öffnen eines Hauptschalters, so dass der Strom lediglich durch den Nebenstrompfad fließen kann. Dabei kann der fließende Strom bedingt durch den vorliegenden Widerstand in den Nebenstrompfad begrenzt werden. Dadurch, dass während des normalen Betriebs des Batteriesystems der Strom sowohl durch den Hauptstrompfad als auch durch die Nebenstrompfad fließen kann, kann das Auftreten eines Lichtbogens bei dem Öffnen des Hauptstrompfads signifikant reduziert werden, da durch den Nebenstrompfad die Transiente abgebaut werden kann, wie dies vorstehend im Detail erläutert ist.

Ein vorbeschriebenes Batteriesystem kann dabei ein besonders vorteilhaftes Verfahren zum Ansteuern der elektronischen Schalteinheit und dabei insbesondere der Schalter zum Unterbrechen des Hauptstrompfades beziehungsweise des Nebenstrompfades ermöglichen. Beispielsweise durch das Dimensionieren des Hauptschalters sowie des Nebenschalters, wobei die entsprechenden Schalter und die entsprechenden Strompfade abweichend von den gemäß dem Stand der Technik üblichen Dimensionierung ausgestaltet sein können oder beispielsweise durch das Ausbilden des Widerstands in dem Nebenstrompfad lässt sich ein derartiges System besonders kostengünstig ausgestalten. Denn schon dadurch, dass der Widerstand in dem Nebenstrompfad deutlich reduziert werden kann, lassen sich Kosten reduzieren, denn die Kosten der entsprechenden Komponenten steigen überproportional mit der Stromtrennfähigkeit. Wenn nun in beiden Pfaden weniger Strom fließt, kann die maximale Stromtrennfähigkeit signifikant reduziert werden, was eine deutliche Kostenersparnis mit sich bringt. Neben der Kostenersparnis ermöglicht das vorbeschriebene Batteriesystem einen signifikanten Sicherheitsgewinn.

In vorteilhafter Weise kann dabei ein Nebenwiderstand vorliegen, der einen elektrischen Widerstandswert in einem Bereich von kleiner oder gleich 30 Ohm, insbesondere kleiner oder gleich 15 Ohm, beispielsweise kleiner oder gleich 8 Ohm aufweist. Insbesondere in dieser Ausgestaltung wird der Strom somit in dem Nebenstrompfad vergleichsweise gering begrenzt, dass während des normalen Betreibens ein relativ großer Anteil an Strom durch die Nebenstrompfad und nur ein vergleichsweise begrenzter Strom durch den Hauptstrompfad fließen kann. Somit kann bei einem Öffnen des Hauptstrompfads bei dem Vorliegen eines Fehlers in besonders vorteilhafter Weise und besonders effektiv das Auftreten eines Lichtbogens reduziert werden.

Der Nebenwiderstand weist einen veränderbaren Widerstandswert auf. Beispielsweise kann der Nebenwidersand als eine Parallelschaltung von mehreren Teilwiderständen ausgestaltet sein. Dabei werden nach dem Detektieren eines sicherheitskritischen Zustands die einzelnen Parallelpfade beziehungsweise parallelen Teilwiderstände sequenziell zugeschaltet, so dass der durch den Nebenstrompfad fließende Strom sukzessive reduziert wird. Das Schalten erfolgt hierbei beispielsweise über Leistungs-MOSFETs. Somit kann der Widerstand ein variabler Widerstand sein, der beim Öffnen des Hauptschalters möglichst niederohmig ist, um einen Lichtbogen zu vermeiden. Erst nachdem der Lichtbogen im Hauptschütz erloschen ist, etwa in einem Bereich von 10µs - 100ms, wird der Widerstandswert auf einen höheren Wert geregelt und der Strom mit einer möglichst geringen Transiente abgeschaltet. Insbesondere können bei der vorbeschriebenen Ausgestaltung in dem Nebenstrompfad Ströme auftreten, die in einem Bereich von 10A bis kurzzeitig 1000A liegen (. Selbst, wenn durch eine derartige Auslegung des Schalters höhere Kosten entstehen, können diese durch eine vergleichsweise geringere Dimensionierung des Hauptschalters, wie dies nachstehend beschrieben ist, ausgeglichen werden, so dass die Kosten zusammenfassend gleich oder geringer sind verglichen mit den Lösungen aus dem Stand der Technik.

Dabei kann es vorgesehen sein, dass der Hauptschalter und der Nebenschalter gleich beziehungsweise identisch ausgestaltet sind. Diese Ausgestaltung kann insbesondere durch die Auswahl des Widerstands in den Nebenstrompfad ermöglicht werden, welcher das definierte Aufteilen des fließenden Stroms in Hauptstrompfad und Nebenstrompfad ermöglicht. In dieser Ausgestaltung kann ein besonders einfaches Herstellen des Schalters beziehungsweise ein besonders kostengünstiges Ausstatten des Batteriesystems mit Schaltern ermöglicht werden, da eine Herstellung mit gleichen Schaltern und somit mit einer geringeren Anzahl an unterschiedlichen Teilen ermöglicht werden kann. Diese Ausgestaltung ermöglicht ferner eine vereinfachte Instandhaltung des Batteriesystems, da eine geringe Anzahl an Teilen vorgehalten werden braucht.

Hinsichtlich weiterer Vorteile und Merkmale des vorbeschriebenen Batteriesystems wird hiermit explizit auf die Erläuterungen im Zusammenhang mit dem erfindungsgemäßen Verfahren sowie den Figuren verwiesen. Auch sollen erfindungsgemäße Merkmale und Vorteile des erfindungsgemäßen Batteriesystems für das erfindungsgemäße Verfahren anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen.

### Beispiele und Zeichnung

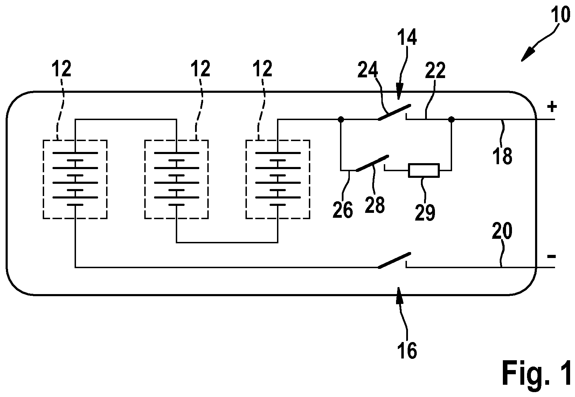

Weitere Vorteile und vorteilhafte Ausgestaltungen der erfindungsgemäßen Gegenstände werden durch die Zeichnung veranschaulicht und in der nachfolgenden Beschreibung erläutert. Dabei ist zu beachten, dass die Zeichnung nur beschreibenden Charakter hat und nicht dazu gedacht ist, die Erfindung in irgendeiner Form einzuschränken. Es zeigt
- Fig. 1: eine schematische Darstellung einer Ausgestaltung eines Batteriesystems gemäß der Erfindung.

In der Figur 1 ist ein Batteriesystem 10 zum Versorgen eines Verbrauchers mit elektrischer Leistung gezeigt. Beispielsweise ist das Batteriesystem 10 Bestandteil eines elektrisch angetriebenen Fahrzeugs.

Das Batteriesystem 10 gemäß Figur 1 weist eine Batterie mit einer Mehrzahl an Batteriezellen 12 auf, die in Reihe geschaltet sind. Die Batterie beziehungsweise die Batteriezellen 12 sind dabei in an sich bekannter Weise durch einen Pluspol und einen Minuspol durch entsprechende Traktionsleitungen 18, 20 mit einem Verbraucher verbindbar, um den Verbraucher mit elektrischer Energie zu versorgen. In der dem Pluspol wie auch in der dem Minuspol zugeordneten Traktionsleitung 18, 20 ist jeweils eine elektronische Schalteinheit 14, 16 zum selektiven Öffnen oder Schließen der jeweiligen Traktionsleitung 18, 20 vorgesehen. Dabei kann eine der Schalteinheiten 14, 16 einen einzelnen Schalter umfassen, insbesondere kann eine oder können beide der Schalteinheiten 14, 16 eine wie nachfolgend in nicht beschränkender Weise für die Schalteinheit 14 beschriebene Ausgestaltung aufweisen.

Die Schalteinheit 14 ist zwischen der Batterie beziehungsweise den Batteriezellen 12 und dem nicht dargestellten Verbraucher in der Traktionsleitung 18 angeordnet. Die elektronische Schalteinheit 14 weist dabei einen ersten Strompfad beziehungsweise Hauptstrompfad 22 auf, der durch einen Hauptschalter 24 öffenbar ist. Weiterhin weist die elektronische Schalteinheit 14 einen zu dem ersten Hauptstrompfad 22 parallel angeordneten Nebenstrompfad 26 auf, der durch einen Nebenschalter 28 öffenbar ist. Weiterhin ist in dem Nebenstrompfad 26 ein Nebenwiderstand 29 angeordnet. Der Nebenstrompfad 26 ist dabei derart angeordnet, dass durch ihn der Hauptstrompfad 22 überbrückbar ist.

Bezüglich des Nebenwiderstands 29 kann dieser derart ausgestaltet sein, dass dieser einen elektrischen Widerstandswert in einem Bereich von kleiner oder gleich 30 Ohm, insbesondere kleiner oder gleich 15 Ohm, beispielsweise kleiner oder gleich 8 Ohm aufweist. Beispielsweise kann der Nebenwiderstand 29 einen veränderbaren Widerstandswert aufweisen, etwa durch das Vorsehen einer Parallelschaltung einer Mehrzahl an selektiv zuschaltbaren und abschaltbaren Teilwiderständen.

Weiterhin können Nebenschalter 28 und Hauptschalter 24 identisch ausgestaltet sein.

Durch das Vorsehen eines wie vorbeschriebenen ausgestalteten Batteriesystems 10 kann, um das Auftreten eines Lichtbogens bei einem Öffnen des Hauptstrompfads 22 zu reduzieren, ein Verfahren zum Betreiben eines derartigen Batteriesystems 10 die folgenden Verfahrensschritte aufweisen:
a) Versorgen des Verbrauchers mit elektrischer Leistung, wobei der Hauptstrompfad 22 und der Nebenstrompfad 26 geschlossen sind;
b) Detektieren eines sicherheitskritischen Zustands, wie insbesondere eines definiert erhöhten Stroms;
c) Öffnen des Hauptstrompfads 22.

In besonders vorteilhafter Weise kann dabei bei einem Versorgen des Verbrauchers mit Energie gemäß Verfahrensschritt a) das Verhältnis der durch den Hauptstrompfad und durch den Nebenstrompfad fließenden Strom in einem Verhältnis von größer oder gleich 10/1 bis kleiner oder gleich 10⁵/1 liegen.

## Patentansprüche

1. Verfahren zum Betreiben eines Batteriesystems (10) zum Versorgen eines Verbrauchers mit elektrischer Leistung, aufweisend wenigstens eine zwischen einer Batterie und dem Verbraucher angeordnete elektronische Schalteinheit (14), wobei wenigstens eine elektronische Schalteinheit (14) einen Hauptstrompfad (22) aufweist, der insbesondere durch einen Hauptschalter (24) offenbar ist, und wobei die elektronische Schalteinheit (14) einen zu dem Hauptstrompfad (22) parallel angeordneten öffenbaren Nebenstrompfad (26) aufweist, in dem ein Nebenwiderstand (29) und gegebenenfalls ein Nebenschalter (28) angeordnet ist, aufweisend die Verfahrensschritte:
a) Versorgen des Verbrauchers mit elektrischer Leistung, wobei der Hauptstrompfad (22) und der Nebenstrompfad (26) geschlossen sind;
b) Detektieren eines sicherheitskritischen Zustands;
c) Öffnen des Hauptstrompfads (22), **dadurch gekennzeichnet, dass**
der Widerstandswert des Nebenwiderstands (29) verändert wird.

2. Verfahren nach Anspruch 1, **dadurch gekennzeichnet, dass** der Widerstandswert des Nebenwiderstands nach Verfahrensschritt a) sukzessive vergrößert wird.

3. Verfahren nach einem der Ansprüche 1 oder 2, **dadurch gekennzeichnet, dass** bei einem Versorgen des Verbrauchers mit elektrischer Leistung gemäß Verfahrensschritt a) das Verhältnis des durch den Hauptstrompfad (22) und durch den Nebenstrompfad (26) fließenden Stroms in einem Verhältnis von größer oder gleich 10/1 bis kleiner oder gleich 10⁵/1 liegt

4. Verfahren nach einem der Ansprüche 1 bis 3, **dadurch gekennzeichnet, dass** das Verfahren den weiteren Schritt umfasst:
d) Öffnen des Nebenstrompfads (26).

5. Verfahren nach Anspruch 4, **dadurch gekennzeichnet, dass** Verfahrensschritt d) durchgeführt wird durch das Öffnen eines Nebenschalters (28) oder durch das Ansteuern des Nebenwiderstands (29) mit variablem Widerstandswert.

6. Verfahren nach einem der Ansprüche 1 bis 5, **dadurch gekennzeichnet, dass** als sicherheitskritischer Zustand das Fließen eines definiert erhöhten Stroms detektiert wird.

7. Batteriesystem, ausgestaltet zum Ausführen eines Verfahrens nach einem der Ansprüche 1 bis 6, aufweisend wenigstens eine zwischen einer Batterie und dem Verbraucher angeordnete elektronische Schalteinheit (14), wobei wenigstens eine elektronische Schalteinheit (14) einen Hauptstrompfad (22) aufweist, der insbesondere durch einen Hauptschalter (24) öffenbar ist, und wobei die elektronische Schalteinheit (14) einen zu dem Hauptstrompfad (22) parallel angeordneten öffenbaren Nebenstrompfad (26) aufweist, in dem ein Nebenwiderstand (29) und gegebenenfalls ein Nebenschalter (28) angeordnet ist, **dadurch gekennzeichnet, dass** der Nebenwiderstand (29) einen veränderbaren Widerstandswert aufweist.

8. Batteriesystem nach Anspruch 7, **dadurch gekennzeichnet, dass** der Nebenwiderstand (29) einen elektrischen Widerstandswert in einem Bereich von kleiner oder gleich 30 Ohm, insbesondere kleiner oder gleich 15 Ohm, beispielsweise kleiner oder gleich 8 Ohm aufweist.

9. Batteriesystem nach einem der Ansprüche 7 oder 8, **dadurch gekennzeichnet, dass** der Hauptschalter (24) und der Nebenschalter (28) identisch ausgestaltet sind.

## Claims

1. Method for operating a battery system (10) for supplying electrical power to a load, having at least one electronic switching unit (14) arranged between a battery and the load, wherein at least one electronic switching unit (14) has a main current path (22), which can be opened, in particular, by a main switch (24), and wherein the electronic switching unit (14) has a shunt current path (26), which can be opened and is arranged in parallel with the main current path (22), in which shunt current path a shunt resistor (29) and possibly a shunt switch (28) are arranged, having the following method steps:
a) supplying electrical power to the load, wherein the main current path (22) and the shunt current path (26) are closed;
b) detecting a safety-critical state;
c) opening the main current path (22), **characterized in that**
the resistance value of the shunt resistor (29) is changed.

2. Method according to Claim 1, **characterized in that** the resistance value of the shunt resistor is gradually increased after method step a).

3. Method according to either of Claims 1 and 2, **characterized in that**, when the load is supplied with electrical power as per method step a), the ratio of the current flowing through the main current path (22) and through the shunt current path (26) is in a ratio of greater than or equal to 10/1 to less than or equal to 10⁵/1.

4. Method according to one of Claims 1 to 3, **characterized in that** the method comprises the following further step of:
d) opening the shunt current path (26).

5. Method according to Claim 4, **characterized in that** method step d) is carried out by opening a shunt switch (28) or by actuating the shunt resistor (29) with a variable resistance value.

6. Method according to one of Claims 1 to 5, **characterized in that** the flow of a current, which is increased in a defined manner, is detected as safety-critical state.

7. Battery system, designed to execute a method according to one of Claims 1 to 6, having at least one electronic switching unit (14) arranged between a battery and the load, wherein at least one electronic switching unit (14) has a main current path (22), which can be opened, in particular, by a main switch (24), and wherein the electronic switching unit (14) has a shunt current path (26), which can be opened and is arranged in parallel with the main current path (22), in which shunt current path a shunt resistor (29) and possibly a shunt switch (28) are arranged, **characterized in that** the shunt resistor (29) has a variable resistance value.

8. Battery system according to Claim 7, **characterized in that** the shunt resistor (29) has an electrical resistance value in a range of less than or equal to 30 ohms, in particular less than or equal to 15 ohms, for example less than or equal to 8 ohms.

9. Battery system according to either of Claims 7 and 8, **characterized in that** the main switch (24) and the shunt switch (28) are of identical design.

## Revendications

1. Procédé servant à faire fonctionner un système de batterie (10) destiné à alimenter en énergie électrique un consommateur, comprenant au moins une unité de commutation électronique (14) disposée entre une batterie et le consommateur, dans lequel au moins une unité de commutation électronique (14) comporte un trajet de courant principal (22) pouvant être ouvert, en particulier par un commutateur principal (24), et dans lequel l'unité de commutation électronique (14) comporte un trajet de courant secondaire (26) pouvant être ouvert disposé parallèlement au trajet de courant principal (22), sur lequel sont disposés une résistance secondaire (29) et éventuellement un commutateur secondaire (28), comportant les étapes de procédé consistant à :
a) alimenter le consommateur en énergie électrique, le trajet de courant principal (22) et le trajet de courant secondaire (26) étant fermés ;
b) détecter une situation critique en matière de sécurité ;
c) ouvrir le trajet de courant principal (22),
**caractérisé en ce que** la valeur de résistance de la résistance secondaire (29) est modifiée.

2. Procédé selon la revendication 1, **caractérisé en ce que** la valeur de résistance de la résistance secondaire est augmentée successivement après l'étape de procédé a).

3. Procédé selon l'une des revendications 1 ou 2, **caractérisé en ce que**, lors d'une alimentation du consommateur en énergie électrique conformément à l'étape de procédé a), le rapport des courants passant par l'intermédiaire du trajet principal (22) et par l'intermédiaire du trajet de courant secondaire (26) va d'une valeur supérieure ou égale à 10/1 à une valeur inférieure ou égale à 10⁵/1.

4. Procédé selon l'une des revendications 1 à 3, **caractérisé en ce que** le procédé comprend l'étape supplémentaire consistant à :
d) ouvrir le trajet secondaire (26).

5. Procédé selon la revendication 4, **caractérisé en ce que** l'étape de procédé d) est effectuée en ouvrant un commutateur secondaire (28) ou en commandant la résistance secondaire (29) avec une valeur de résistance variable.

6. Procédé selon l'une des revendications 1 à 5, **caractérisé en ce que** le passage d'un courant accru défini est détecté comme étant un état critique en matière de sécurité.

7. Système de batterie conçu pour la mise en oeuvre d'un procédé selon l'une des revendications 1 à 6, comprenant au moins une unité de commutation électronique (14) disposée entre une batterie et le consommateur, dans lequel au moins une unité de commutation électronique (14) comporte un trajet de courant principal (22) pouvant être ouvert, en particulier par un commutateur principal (24), et dans lequel l'unité de commutation électronique (14) comporte un trajet secondaire (26) pouvant être ouvert disposé parallèlement au trajet de courant principal (22) et dans lequel sont disposés une résistance secondaire (29) et éventuellement un commutateur secondaire (28), **caractérisé en ce que** la résistance secondaire (29) présente une valeur de résistance modifiable.

8. Système de batterie selon la revendication 7, **caractérisé en ce que** la résistance secondaire (29) présente une valeur de résistance électrique se situant dans une plage inférieure ou égale à 30 ohms, en particulier inférieure ou égale à 15 ohms, par exemple inférieure ou égale à 8 ohms.

9. Système de batterie selon l'une des revendications 7 ou 8, **caractérisé en ce que** le commutateur principal (24) et le commutateur secondaire (28) sont de conception identique.
